# EUROPEAN PATENT SPECIFICATION

(11) **EP 0 948 839 B1**
(45) Date of publication and mention of the grant of the patent: **19.06.2002**
(21) Application number: 98953965.5
(22) Date of filing: 22.10.1998
(51) Int. Cl.: H03H 17/02

(54) **INTEGRATED FILTER AND DETECTION PROCESS**
INTEGRIERTES FILTER UND DETEKTIONSVERFAHREN
PROCESSUS INTEGRE DE FILTRAGE/DETECTION

(30) Priority: 30.10.1997 US 960957
(43) Date of publication of application: 13.10.1999
(73) Proprietor: Raytheon Company, El Segundo, California 90245-0902 (US)
(72) Inventor: JOHNSTON, W., Scott, Tucson, AZ 85748-8305 (US); DOUGLAS, Dave, S., Tucson, AZ 85715-5203 (US)
(74) Representative: Jackson, Richard Eric
(86) International application number: US9822558
(87) International publication number: WO9923758

(56) References cited:
- US-A- 4 079 376
- US-A- 5 311 306

## Description

### BACKGROUND

The present invention relates generally to signal processors and signal processing methods, and more particularly, to an integrated filter and detection process for use in target tracking and signal processors, and the like.

Traditional signal detection processing uses a filter process followed by a separate thresholding process to produce target detections. For example, the assignee of the present invention manufactures a tracking system that utilizes a hardware zero approaching process (ZAP) filter followed by a thresholding process implemented on a TMS320C30 digital signal processor. The ZAP filter and digital signal processor require two Augat cards. Another target tracker manufactured by the assignee of the present invention utilizes a image processor system manufactured by DataCube to perform ZAP filtering followed by a Rockwell ESPPD (C30 based system) to perform the thresholding process. This implementation requires four VME 6U cards.

Therefore, it would be an advantage to have a signal processor and filter and detection processing method that may be used in target trackers, or the like, that reduces the computational resources required by the signal processor. Accordingly, it is an objective of the present invention to provide for an integrated filter and detection process for use in target tracking signal processors, and the like.

### SUMMARY OF THE INVENTION

To meet the above and other objectives, the present invention provides for a integrated filter and detection process and processor that substantially reduces the processing requirements of a signal processing system in which they employed. In the integrated filter and detection process and processor, a first pass filter filters input data comprising a plurality of data entries. First pass threshold processing is performed on the filtered input data by thresholding each of the plurality of data entries using a predetermined threshold. This generates a thresholded first pass data list. A second pass filter having a predetermined number of filter stages is then used to filter the thresholded data entries. Final thresholding process is performed on the filtered data entries generated by the filter stages of the second pass filter. This generates a thresholded data list that is output by the process or processor.

As was mentioned above, traditional signal detection processing uses a filter process followed by a separate thresholding process to produce target detections. For certain classes of filters, it has been found that integration of the two processes results in a single processing method that requires significantly fewer operations to accomplish the detection process. The present invention provides for such an integration.

The class of filters are those that choose some combination of multiple subfilter outputs to produce a result. Given knowledge of the desired thresholding process and the characteristics of each filter, the threshold can be applied individually to each subfilter output, and a determination can be made whether the filter will produce a detection or not. If the determination is made that no detection is produced, the remaining subfilters of the second pass filter need not be performed, reducing the overall expected operation count.

The present invention detects signals in the presence of noise, such as a target in the presence of background clutter, for example. The present invention has the advantage that it is simpler to implement than conventional processes, and generally performs faster than prior signal detection systems and processes. The present invention thus simplifies hardware design and greatly reduces cycle time to production. The present invention may be beneficially used in image-based target tracking systems, such as missile tracking systems, and the like.

### BRIEF DESCRIPTION OF THE DRAWINGS

The various features and advantages of the present invention may be more readily understood with reference to the following detailed description taken in conjunction with the accompanying drawings, wherein like reference numerals represent like structural elements, and in which
Fig. 1 illustrates a prior art processing method having separate filter and detection processes; and
Fig. 2 illustrates steps involved in an integrated filter and detection processing method in accordance with the principles of the present invention.

### DETAILED DESCRIPTION

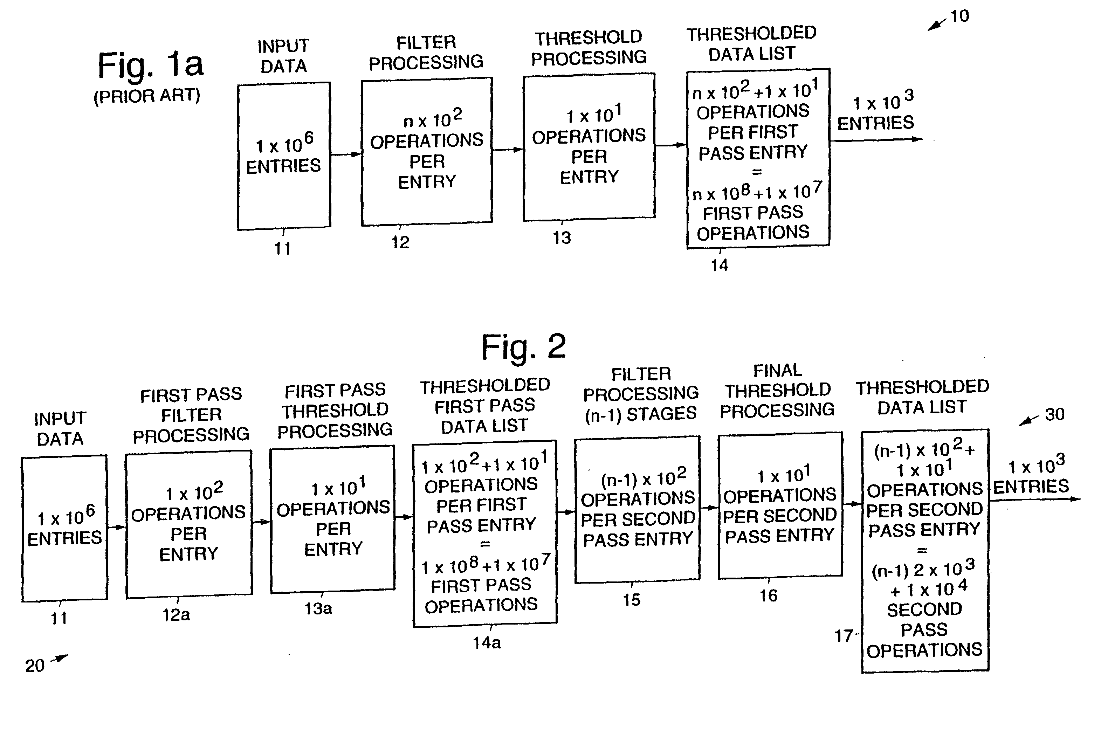

Referring to the drawing figures, Fig. 1 illustrates a prior art processing method 10 having separate filter and detection processes. In the prior art processing method 10, input data 11, comprising 1x10⁶ data entries are processed by a filter process 12. The filter process 12 generates nx10² operations per entry. Each of the data entries is processed by a thresholding process 13. The thresholding process 13 generates nx10¹ operations per entry, and produces a threshold data list 14 containing 1x10³ entries. The total number of operations performed in the prior art processing method 10 is therefore nx10⁸ + 1x10⁷ operations.

Referring to Fig. 2, it illustrates steps involved in an integrated filter and detection processing method 20 in accordance with the principles of the present invention. The integrated filter and detection processing method 20 comprises the following steps. The integrated filter and detection processing method 20 may be readily implemented by those skilled in the art as part of a signal processor 30 to detect signals in an image that are in the presence of noise, such as a target obscured by background clutter, for example.

Input data 11, comprising 1x10⁶ data entries are processed by a first pass filter process 12a. The first pass filter process 12a generates 1x10² operations per data entry. Each of the data entries is processed by a first pass thresholding process 13a. The first pass thresholding process 13a generates 1x10¹ operations per first pass data entry. A thresholded first pass data list 14a is then generated, that is generated as a result of 1x10² + 1x10¹ operations per first pass data entry. The total number of operations performed during first pass filter and threshold processes 12a, 13a is therefore 1x10⁸ + 1x10⁷ operations.

The first pass data list is then passed to a second pass filter process 15 having (n-1) filter process stages 15. The second pass filter process 15 generates (n-1)x10² operations per second pass data entry. Each of the data entries is then processed by a final thresholding process 16. The final thresholding process 16 generates 1x10¹ operations per second pass data entry. A thresholded data list 17 is then generated that contains 1x10³ entries. The thresholded data list 17 is generated as a result of (n-1)x10² + 1x10¹ operations per second pass data entry. The total number of operations performed during second pass filter and threshold processes 15, 16 is therefore 2(n-1)x10³ + 2x10⁴ operations. The total number of operations performed during integrated filter and threshold process 10 is therefore 1x10⁸ + 1x10⁷ + (n-1)x10⁵ + 1x10⁴ operations. The integrated filter and threshold process 20 therefore saves approximately (n-1)x10⁸ operations.

In the integrated filter and threshold process 20, the detection and thresholding process 13a is combined with the filtering process 12a such that a determination can be made regarding a valid detection at the earliest instance in the processing cycle (i.e., the first pass). The threshold is passed to the second pass filtering process 15 and the second pass filtering process 15 is terminated for this data entry when the threshold is not met. The second pass filtering process 15 may be terminated if any of the submasks fail to meet the threshold, such that the overall output fails. This is generally implemented by combining subfilters such that an "ending" of the signals is required for a successful output. In this configuration, the overall filter fails to detect a "pass threshold" if any one of the subfilters fails the threshold test. If the first pass filter 12a fails the threshold test, this eliminates the operations on the remaining n-1 filters of the second pass filtering process 15, which reduces the number of operations for the entire integrated process 20.

For a particular threshold that generates a probability of false alarm of 1x10⁻³, for example, only one out of every thousand pixels in a processed image requires processing by the n-1 filters of the second pass filtering process 15. This almost immediately translates into a 1/n reduction of work expended by the filtering processes 12a, 15 of the integrated process 20.

The thresholding process requirements in the integrated process 20 are different from the prior art approach. The change is caused by the second pass comparisons to the threshold performed in the final threshold process 16. If the first pass filter 12a passes the threshold, then a decision must be made to either test the threshold at each of the (n-1) stages of the second pass filtering process 15, or complete subfilter processing for all of the (n-1) stages of the second pass filtering process 15 and then threshold at the end of the n^{th} subfilter stage. Either decision requires fewer threshold tests by the final threshold process 16 compared to the prior art process 10.

The false alarm rate after the first pass filter and threshold processes 12a, 13a is larger than the overall false alarm rate of the entire integrated process 20. This is due to actions of the second stage subfilters of the second pass filtering process 15 on the data entries. The subfilters of the second pass filtering process 15 reject data and the false alarm rate is the overall expected false alarm rate of the integrated process 20.

For this reason, the first pass filter process 12a processes the data entries in a preferred direction, if one exists. For example, if a line (a target track, for example) exists in a two-dimensional image, processing in the normal (cross track) direction is not performed first. Instead, processing in an in-line (along track) direction is performed to prevent saturation as a result of each line crossing becoming a first pass event. This is the case near a horizon in certain image processing scenarios where vertical processing generates a first pass threshold exceedance located at each vertical scan. If a two-dimensional filter is performed in the first pass and second pass filter processes 12a, 15, it is preferable to perform the first pass filter process 12a in a horizontal direction, thus reducing the first pass exceedances and therefore the overall processing throughput of the integrated process 20.

The integrated filter and threshold process 20 was implemented and tested. The integrated filter and threshold process 20 was coded in FORTRAN and used a ZAP filter to implement the filtering process of the first pass filter process 12a. The output of a horizontal arm of the ZAP filter was compared to positive and negative thresholds in the first pass threshold process 13a. If the output passed this threshold, then the remaining three arms of the ZAP filter (the second pass filter process 15) were evaluated and the overall output of the ZAP filter was then compared to the threshold (the final threshold process 16). Processing time required by the present integrated process 20 was reduced compared to the conventional process 10.

In addition, the integrated filter and threshold process 20 was implemented as part of an Ada simulation and on a Rockwell ESPPD processing system. This simulation was done to demonstrate the integrated threshold technique for ZAP channel processing of a missile tracker developed by the assignee of the present invention. This simulation also demonstrated a significant timing benefit provided by the present integrated process 20.

Thus, an integrated filter and detection process for use in target tracking processors has been disclosed. It is to be understood that the described embodiment is merely illustrative of some of the many specific embodiments which represent applications of the principles of the present invention. Clearly, numerous and other arrangements can be readily devised by those skilled in the art without departing from the scope of the invention as defined by the claims.

## Claims

1. A filter and detection process (20) **characterized by** the steps of:
a first pass filter process (12a) for filtering input data comprising a plurality of data entries;
a first pass thresholding process (13a) for processing the filtered input data by thresholding each of the plurality of data entries using a predetermined threshold, and for generating a thresholded first pass data list (14a);
a second pass filter process (15) having a predetermined number of filter process stages for filtering each of the thresholded data entries;
a final thresholding process (16) for processing the filtered data entries generated by the filter process stages of the second pass filter process, and for generating a thresholded data list (17) that is output by the process.

2. A signal processor (30) for detecting signals in an image that are obscured by noise, **characterized by**:
first pass filter apparatus (12a) adapted to filter input data comprising a plurality of data entries;
first pass thresholding apparatus (13a) adapted to process the filtered input data by thresholding each of the plurality of data entries using a predetermined threshold, and adapted to generate a thresholded first pass data list (14a);
second pass filter apparatus (15) having a predetermined number of filter stages adapted to filter each of the thresholded data entries;
final thresholding apparatus (16) adapted to process the filtered data entries generated by the filter stages of the second pass filter apparatus, and adapted to generate a thresholded data list (17) that is output by the signal processor.

## Patentansprüche

1. Filterungs- und Detektionsverfahren (20), **gekennzeichnet durch** die folgenden Schritte:
- einen Erstdurchgangs-Filterungsvorgang (12a) zum Filtern von Eingangsdaten, die eine Vielzahl von Dateneingaben enthalten;
- einen Erstdurchgangs-Schwellwertprüfungsvorgang (13a) zur Verarbeitung der gefilterten Eingangsdaten unter Verwendung eines vorbestimmten Schwellwertes und zur Erzeugung einer schwellwertprüfungsunterzogenen Datenliste (14a) des ersten Durchgangs;
- einen Zweitdurchgangs-Filterungsvorgang (15) mit einer vorbestimmten Zahl von Filterungsstufen zum Filtern jeder der schwellwertprüfungsunterzogenen Dateneingaben; und
- einen abschließenden Schwellwertprüfungsvorgang (16) zur Verarbeitung der gefilterten Dateneingaben, die **durch** die Filterungsstufen des Zweitdurchgangs-Filterungsvorgangs erzeugt worden sind, und zur Erzeugung einer schwellwertprüfungsunterzogenen Datenliste (17), die als Verfahrensergebnis ausgegeben wird.

2. Signalverarbeitungseinrichtung (30) zum Detektieren von Signalen innerhalb eines Bildes, wobei die Signale durch Störungen überschattet sind, **gekennzeichnet durch**:
- eine Erstdurchgangs-Filteranordnung (12a), welche so ausgebildet ist, daß sie Eingangsdaten, die eine Vielzahl von Dateneingaben enthalten, filtert;
- eine Erstdurchgangs-Schwellwertprüfungseinrichtung (13a), welche so ausgebildet ist, daß sie die gefilterten Eingangsdaten **durch** Schwellwertprüfung jeder der Vielzahl von Dateneingaben unter Verwendung eines vorbestimmten Schwellwertes verarbeitet, und weiter so ausgebildet ist, daß sie eine schwellwertprüfungsunterzogene Datenliste (14a) des ersten Durchgangs erzeugt;
- eine Zweitdurchgangs-Filtereinrichtung (15) mit einer vorbestimmten Anzahl von Filterstufen, welche so ausgebildet ist, daß sie jede der schwellwertprüfungsunterzogenen Dateneingaben filtert; und
- eine End-Schwellwertprüfungseinrichtung (16), welche so ausgebildet ist, daß sie die gefilterten Dateneingaben, die **durch** die Filterstufen der Zweitdurchgangs-Filtereinrichtung erzeugt worden sind, verarbeitet, und weiter so ausgebildet ist, daß sie eine schwellwertprüfungsunterzogene Datenliste (17) erzeugt, die von der Signalverarbeitungseinrichtung als Ausgang ausgegeben wird.

## Revendications

1. Procédé de filtrage et de détection (20) **caractérisé par** les étapes qui comprennent:
un premier processus de passage par un filtre (12a) pour filtrer des données d'entrée comprenant une pluralité d'entrées de données;
un premier processus de passage par une fixation de seuil (13a) pour traiter les données d'entrée filtrées en fixant un seuil pour chacune de la pluralité d'entrées de données en utilisant un seuil prédéterminé, et pour générer une première liste de données passantes (14a) pour lesquelles un seuil est fixé;
un second processus de passage par un filtre (15) ayant un nombre prédéterminé d'étages de traitement par filtre pour filtrer chacune des entrées de données pour lesquelles un seuil est fixé;
un processus final de fixation de seuil (16) pour traiter les entrées de données filtrées générées par les étages de traitement par filtre du second processus de passage par un filtre, et pour générer une liste (17) de données pour lesquelles un seuil est fixé, qui est délivrée en sortie par le procédé.

2. Processeur (30) de signaux destiné à détecter dans une image des signaux occultés par un bruit, **caractérisé par**:
un premier appareil (12a) à filtre de passage conçu pour filtrer des données d'entrée comprenant une pluralité d'entrées de données;
un premier appareil (13a) de fixation de seuil de passage conçu pour traiter les données d'entrée filtrées en fixant un seuil pour chacune de la pluralité d'entrées de données en utilisant un seuil prédéterminé, et conçu pour générer une première liste de données passantes (14a) pour lesquelles un seuil est fixé;
un second appareil de passage par un filtre (15) ayant un nombre prédéterminé d'étages de filtres conçu pour filtrer chacune des entrées de données pour lesquelles un seuil est fixé;
un appareil (16) de fixation de seuil final conçu pour traiter les entrées de données filtrées générées par les étages de filtres du second appareil de passage par un filtre, et conçu pour générer une liste de données (17) pour lesquelles un seuil est fixé, qui est délivrée en sortie par le processeur de signaux.
